# EUROPÄISCHE PATENTSCHRIFT

(11) **EP 3 055 401 B1**
(45) Veröffentlichungstag und Bekanntmachung des Hinweises auf die Patenterteilung: **23.11.2022**
(21) Anmeldenummer: 14784431.0
(22) Anmeldetag: 13.10.2014
(51) Int. Cl.: C11D 17/00, C11D 11/00, C11D 3/20, C11D 3/32

(54) **VERWENDUNG VON MEHRPHASENSFLÜSSIGKEITEN ZUR VERNETZTEN FOTORESIST-STRIPPING**
USE OF PLURIPHASIC LIQUIDS FOR STRIPPING CROSSLINKED PHOTORESIST
UTILISATION DE LIQUIDES À PLUSIEURS PHASES POUR ÉLIMINER DES PHOTORÉSISTS RÉTICULÉS

(30) Priorität: 11.10.2013 DE 102013016870
(43) Veröffentlichungstag der Anmeldung: 17.08.2016
(73) Patentinhaber: Intelligent fluids GmbH, 04229 Leipzig (DE)
(72) Erfinder: SCHUMANN, Dirk, 04229 Leipzig (DE)
(74) Vertreter: Scheele Jaeger Wetzel Patentanwälte
(86) Internationale Anmeldenummer: PCT/EP2014/071915
(87) Internationale Veröffentlichungsnummer: WO 2015/052347

(56) Entgegenhaltungen:
- EP-A1- 2 045 320
- WO-A2-2009/037349
- WO-A2-2010/088194
- WO-A2-2010/105842
- WO-A2-2010/108639
- GB-A- 1 369 451
- US-A1- 2002 068 685
- Anonymous: "Dibasic Esters (DBE)", INVISTA - Technical Information , 29. Dezember 2010 (2010-12-29), XP002734495, Gefunden im Internet: URL:https://web.archive.org/web/2010122907 0345/http://cleanersolutions.org/downloads /msds/472/DBE%20TDS-General.pdf [gefunden am 2015-01-15]
- "Trübung", , 23 May 2013 (2013-05-23), Retrieved from the Internet: URL:https://web.archive.org/web/2013052318 3942/https://de.wikipedia.org/wiki/Trübung [retrieved on 2019-01-11]
- "Lutensol XL", BASF , December 2016 (2016-12), Retrieved from the Internet: URL:https://assets-global.website-files.co m/5fc9222730707183b6adc32a/60ad787f5872ae2 72aff6728_Lutensol-XL-40-30222389-1.pdf [retrieved on 2021-06-11]

## Beschreibung

Die vorliegende Erfindung beschreibt die Verwendung neuer Reinigungsmittel auf Basis eines Mehrphasensystems zum Entfernen von vernetzten Fotoresistlacken von Oberflächen.

Das erfindungsgemäße Mehrphasensystem dient insbesondere zur Entfernung von Lacken, Fotoresistlacken, Polymerschichten, Verschmutzungsschichten, Isolationsschichten und Metallschichten von Oberflächen.

Am Anfang der Fertigung eines Siliziumchips steht eine tellergroße Siliciumscheibe aus Silizium-Einkristallen. Die Wafer sind circa 1 mm dick. Auf diese Wafer werden Schicht für Schicht Schaltungen, Leitungen und elektronische Bauteile aufgebaut. Die Fertigung erfolgt in mehreren hundert Prozessschritten in Abhängigkeit von dem jeweils gewünschten Produkt, wobei einige mehrfach wiederholt werden.

Um die gewünschten Strukturen auf die Siliziumoberfläche des Wafers aufzutragen, wird die Oberfläche zunächst mit Dampf oxidiert. Die Oxidschicht ermöglicht eine Strukturierung der Oberfläche durch chemische Umsetzung mit Fluorchemie.

Anschließend wird ein Fotolack aufgetragen. Mit Hilfe von lithographischen Verfahren wird über eine Maske der Fotolack übertragen. Fotolacke werden sowohl in der Mikroelektronik und der Mikrosystemtechnik für die Produktion von Strukturen im Mikro- und Submikrometerbereich sowie bei der Leiterplattenherstellung verwendet. Chemisch gesehen handelt es sich um Mischungen von Präpolymeren oder Polymeren auf Basis von Methylmethacrylat, Novolaken, Polymethylglutarimid oder Epoxidharzen, mit Lösungsmittel und einer fotoempfindlichen Komponente.

Es gibt zwei grundsätzliche Typen von Fotolacken:
- Der sogenannte Negativlack polymerisiert durch Belichtung und gegebenenfalls über eine nachfolgende thermische Stabilisierung, so dass nach der Entwicklung die belichteten Bereiche stehen bleiben. Die über eine Maske geschützten, unbelichteten Bereiche bleiben löslich. Sie werden mit Lösungsmittel oder mit alkalischen Lösungen entfernt. Die Negativ-Fotolacke werden hauptsächlich in der Mikrosystemtechnik für die Produktion von kleinsten Strukturen im Mikro- und Submikrometerbereich eingesetzt.
- Bei den Positivlacken wird der bereits auspolymerisierte Lack durch die Belichtung partiell wieder löslich (depolymerisiert) für entsprechende Entwicklerlösungen. Die stehen gebliebenen Teile des Fotolacks schützen die Teile der Silicium- oder Siliciumdioxid-Oberfläche, die nicht verändert werden soll, während an den freien Stellen eine chemische Modifizierung möglich wird. So kann das Siliciumdioxid über einen Ätzschritt mit Flusssäure oder CF₄ entfernt oder das freie Silicium über einen Ionen-Beschuss dotiert werden.

Die beschriebenen Vorgänge des Beschichtens, Belichtens, Entlackens und Ätzens werden nicht selten mehrere Male mit unterschiedlichen Masken wiederholt.

Die Einsatzgebiete der nasschemischen Verfahren lassen sich dabei wie folgt einteilen:
- Nassätzen:
   bezeichnet das ganzflächige oder teilweise Entfernen von dotierten und undotierten Oxidschichten.
- Waferreinigung:
   Partikel, organische und metallische Substanzen sowie die natürliche Oxidschicht der Siliciumoberfläche müssen kontinuierlich entfernt werden.
- Lackentfernung:
   Nachdem die Struktur unter dem Lack im Ätzverfahren abgetragen wurde, oder der Lack beim Implantationsprozess als Maskierungsschicht gedient hat, muss der Lack entfernt werden.
- Metal Lift-off:
   eine Sonderform der Lackentfernung, bei der zusätzlich auf dem Lack eine aufgebrachte Metallschicht mit entfernt werden muss.
- Rückseitenbehandlung:
   Entfernen von Schichten, die bei Ofenprozessen auf den Waferrückseiten entstanden sind.
- Polymerentfernung:
   Entfernung von Nebenprodukten, die beim Plasmaätzen entstehen und sich auf den Waferscheiben festsetzen.

Reinigungsvorgänge sind also essenziell für die Herstellung von Mikrochips. Die gesamte Breite der oben genannten Reinigungstypen ist bisher jedoch nicht in einem Lösungsansatz abzudecken gewesen.

Einer der wichtigsten und ein immer wiederkehrender Reinigungsvorgang ist die Entfernung des Fotolacks. Nachdem der Fotolack als Maskierungsschicht gedient hat, muss er wieder entfernt werden.

Dies geschieht im Stand der Technik auf zwei verschiedene Arten. Mit der trockenen Plasmaveraschung oder dem nasschemischen Strippen (von englisch to strip = ablösen) des Lacks, beispielsweise mit Hilfe von brennbaren Lösungsmittel, wie Aceton. Im Zuge der Prozesssicherheit und unter besonderer Berücksichtigung der Flammpunkt-Thematik wird jedoch zunehmend nach Einsatzstoffen gesucht, die mit gleicher Geschwindigkeit wie Aceton die Fotolacke entfernen können. Die Schwierigkeit besteht darin, dass Lösungsmittel mit höheren Flammpunkten zunehmend langsamer in der Entfernung von Fotolacken sind. Eine weitere Schwierigkeit ist, dass sich mit dieser Methode nur leicht vernetzte Fotolacke entfernen lassen. Mit steigender Vernetzung sinkt die Löslichkeit der Lacke drastisch.

Stark vernetze oder gar implementierte Fotolacke (nach der Dotierung) sind so schwierig für Lösungsmittel zu entfernen, dass sie durch Ätzschritte oder die Plasmaveraschung entfernt werden müssen. Die Plasmaveraschung führt jedoch nachteilig nicht zu einer vollständigen Resistentfernung, d. h. nach der Veraschung erfolgt in der Regel eine weiterer, also ein zusätzlicher, nasschemischer Reinigungsschritt. Zudem erfolgt die Veraschung bei hohen Temperaturen, was zu Materialstress wie Verformung, thermischen Stress usw. von komplizierten Bauteilen mit unterschiedlichen Materialien mit unterschiedlichen Ausdehnungskoeffizienten führt. Des Weiteren können radikalische Verbrennungsprodukte die Substrat-Oberfläche angreifen noch bevor die aggressiven Radikale sich vereinigen (rekombinieren). Bei kleinen Strukturen kann dadurch eine Strukturzerstörung erfolgen. Die aufwendige Prozesstechnik zur Radikalerzeugung, die notwendige kontrollierte Prozessführung und Entsorgung der Materialien führt zudem zu hohen Kosten.

Auch beim Metal-Lift-Off liegt ein erschwertes Ablösen der Schichten vom Substrat vor. Dieses Verfahren ist ein Standardverfahren bei der Herstellung mikroelektronischer Bauteile, Sensoren oder Laser. Hier muss neben dem Fotoresistlack eine durchgängige Metallschicht mit abgelöst werden.

Der Grad der Automatisierung ist entsprechend hoch. Gängige Maschinen erreichen einen Waferdurchsatz bis zu 80 Stück pro Stunde. Es kommen sowohl Batch wie auch Single-Wafer-Abläufe vor. Ebenso gibt es eine Kombination aus beiden, die sich in der Mehrzahl im Markt wieder finden. Dabei wird in einem beheizbaren Bassin der Stripper auf die gewünschte Temperatur gebracht (z. B. 85°C bei NMP). Während einer bestimmten Einwirkzeit (Soaking Time, etwa 10 bis 30 Minuten) wird der Fotolack an-, auf- oder abgelöst. In einem folgenden Schritt wird jeder Wafer einzeln aus dem Bad entnommen und einem Single-Wafer-Prozess unterzogen. Dabei werden sowohl die Reste des Fotolacks, des Strippers sowohl des Metall-Layers abgeführt. In weiteren Spülschritten, z. B. mit IPA, demineralisiertem Wasser o. ä. wird die Reinheit der Oberfläche erhöht.

Für die Reinigungsprozesse innerhalb der Mikroelektronik besteht deshalb ein hoher Bedarf an effektiveren, Umwelt-, Gesundheits- und Substrat-schonenderen Reinigungsmittel.

WO 2009/037349 A offenbart Mehrphasensreinigungsmittel zur Entfernung von Birkenharz.

Die Aufgabe der vorliegenden Erfindung lag deshalb in der Bereitstellung solcher Mittel zur Verwendung für die Entfernung von vernetzten Fotoresistlacken von Oberflächen.

Diese Mittel sollen als Ersatz der hochaggressiven und damit kritischen Reinigungsmitteln dienen. Der Einsatz von biologisch abbaubaren, toxikologisch und dermatologisch akzeptablen Inhaltsstoffe brächte zudem Einsparungen im Bereich Entsorgung und Arbeitssicherung mit sich. Neben den sicherheitsrelevanten Aspekten soll durch die neuartigen Reinigungsmittel eine Prozessoptimierung im Hinblick auf Zeit und Durchführung realisiert werden. So ist es günstig, Prozessschritte einzusparen, wie beispielsweise den Nassschritt nach der Plasmaveraschung.

Die Aufgabe wurde erfindungsgemäß gelöst durch die Verwendung eines Mehrphasensystems wie im Anspruch 1 beschrieben. Vorteilhafte Ausgestaltungen der Erfindung sind Gegenstand der Unteransprüche.

Die Nephelometric Turbidity Unit (*Nephelometrischer Trübungswert*; NTU) ist eine in der Wasseraufbereitung verwendete Einheit für Trübungsmessungen in Flüssigkeiten. Sie ist die Einheit einer mit einem kalibrierten Nephelometer gemessenen Trübung einer Flüssigkeit.

Gemäß einer Ausführungsform der vorliegenden Erfindung ist das eingesetzte Tensid ein nichtionisches, kationisches, anionisches oder amphoteres Tensid.

Tenside im Sinne dieser Erfindung sind Substanzen, die die Oberflächenspannung einer Flüssigkeit oder die Grenzflächenspannung zwischen zwei Phasen herabsetzen und die Bildung von Dispersionen/Emulsionen ermöglichen oder unterstützen bzw. als Lösungsvermittler wirken. Tenside bewirken, dass zwei eigentlich nicht miteinander mischbaren Flüssigkeiten, wie z. B. Öl und Wasser fein vermengt (dispergiert) werden können. Tenside bilden eine typische Mizellenstruktur, d.h. sie bilden ab einer gewissen Konzentration größere, lockere Strukturen aus, was hier als strukturbildend bezeichnet wird. Tenside im Sinne der Erfindung besitzen eine gerichtete Struktur, wobei ein Teil allgemein aus einem hydrophoben wasserabweisendem Kohlenstoffrest und der andere Teil aus einem hydrophilen wasserliebenden Molekülteil besteht.

Als anionische Tenside können z. B. Alkali- oder AmmoniumSalze von langkettigen Fettsäuren, Alkyl(benzol)sulfonate, Paraffinsulfonate, Bis(2-ethylhexyl) sulfosuccinat, Alkylsulfate, wie v.a. Natriumdodecylsulfat und für spezielle Anwendungen, bei denen es z.B. auf einen Korrosionsschutz ankommt, teilweise auch Alkylphosphate (z.B. Phospholan^{®} PE 65, Akzo Nobel) eingesetzt werden.

Als nichtionische Tenside können Polyalkylenoxid-modifizierte Fettalkohole, wie z.B. Berol^{®}-Typen (Akzo-Nobel) und Hoesch^{®}-T-Typen (Julius Hoesch), sowie auch entsprechende Octylphenole (Triton-Typen) oder Nonylphenole (sofern letztere nicht in großen Mengen in die Umwelt freigesetzt werden). Ein besonderes Einsatzgebiet ermöglichen die Heptamethyltrisiloxane (z.B. Silwet^{®}-Typen, GE Silicones), als Mittel zur starken Erhöhung der Spreiteigenschaften der Flüssigkeiten bzw. zur deutlichen Absenkung der Grenzflächenspannung.

Als kationische Tenside können z.B. Kokosbis (2-hydroxyethyl-)methylammoniumchlorid oder Polyoxyethylen-modifiziertes Talkmethylammoniumchlorid Verwendung finden. Daneben ist auch der Einsatz diverser amphoterer Tenside möglich. Soll ein weiter pH-Bereich abgedeckt werden, so hat sich das Kokosdimethylaminoxid (Aormox^{®} MCD, Akzo-Nobel) als geeignet herausgestellt.

Die Tenside sind im erfindungsgemäßen Mehrphasensystem vorzugsweise von 2 bis 20 Gew.-% enthalten, bezogen auf das Gesamtgewicht des Mehrphasensystems.

Erfindungsgemäß handelt es sich bei den wasserunlöslichen Substanzen um solche mit einer Wasserlöslichkeit kleiner 4 g/l, bevorzugt kleiner 2 g/l. Diese Substanzen sollten vorzugsweise quellende und/oder lösende Eigenschaften aufweisen. Hierzu zählen z. B. Alkane (Benzine) und Cycloalkane (vorzugsweise Cyclohexan). Auch Aromaten wie Toluol, Xylole oder andere Alkylbenzole sowie Naphthaline kommen in Frage. Bevorzugt sind langkettige Alkansäureester, wie fette Öle und Fettsäuremethylester (Biodiesel). Auch Benzylacetat gehört erfindungsgemäss zu den eingesetzten wasserunlöslichen Substanzen. Aber auch Terpene, z.B. monocyclische Monoterpene mit Cyclohexangerüst, können Verwendung finden. Besonders bevorzugt sind hier Terpene aus Cirusfrüchten, wie Citronen- und/oder Orangenterpene bzw. das darin enthaltene Limonen. Die wasserunlöslichen Substanzen sind vorzugsweise von 1,5 - 30 Gew.-% im Mehrphasensystem enthalten.

Gemäß einer Ausführungsform ist es bevorzugt, wenn das Merphasensystem kein Kohlendioxid, insbesondere in Form von überkritischem CO₂ aufweist.

Gemäß einer Ausführungsform ist das mindestens eine Amphiphil ausgewählt aus:
a) Acetoacetaten der Formel II:

   C(R3)3-CO-CH2-CO-O-R4 [Formel II]
wobei
R₃ jeweils unabhängig voneinander Wasserstoff oder ein C₁ bis C₂ Alkyl ist und R₄ ein verzweigtes oder unverzweigtes C₁ bis C₄ Alkyl ist;
oder
Acetoacetaten der Formel III:

CH3-CO-CH2-CO-O-R5 [Formel III]

wobei R₅ ein C₁ bis C₄ Alkyl ist; oder ausgewählt ist aus Ethylacetoacetat, iso-Propylacetoacetat, Methylacetoacetat, n-Butylacetoacetat, n-Propylacetoacetat oder tert-Butylacetoacetat.

Besonders bevorzugt ist, dass das Amphiphil ausgewählt ist aus Acetoacetaten der Formel III:

CH₃-CO-CH₂-CO-O-R₅ [Formel III]

wobei
R₅ ein C₁ bis C₄ Alkyl ist.

Gegenstand der Erfindung ist die Verwendung eines Mehrphasensystems, wie oben beschrieben, zur Entfernung von Fotolacken von Oberflächen. Die Oberfläche ist eine Metalloberfläche, bevorzugt ein Silizuimwafer, wie aus der Chipherstellung bekannt. Insbesondere ist die Oberfläche eine nichtmetallische Oberfläche, bevorzugt ein Silizium- oder Glaswafer und/oder eine Metalloberfläche darauf, bevorzugt Kupfer oder Aluminium. Der Photolack ist ein vernetzter Photolack. Der Vernetzungsgrad beträgt vorzugsweise größer 0,5 %, mehr bevorzugt größer 1 %, noch mehr bevorzugt größer 5 %, noch mehr bevorzugt größer 10 % und am meisten bevorzugt größer 25 %, bezogen auf die Vernetzbaren Gruppen im Fotolack. In vielen Fällen ist auf dem Photolack eine Metallschicht aufgebracht. Insbesondere handelt es sich hier um hochleitende Metalle, wie z.B. Gold. Durch die Verwendung des erfindungsgemäßen Mehrphasensystems wird neben dem Fotolack auch einfach die Metallschicht mit abgelöst. Die Stellen, an denen die Metallschicht direkt mit der Metalloberfläche, beispielsweise einem Siliziumwafer in Kontakt steht, findet keine Ablösung statt. Es verbleibt also eine Metallschicht auf der Metalloberfläche.

Durch die Verwendung des erfindungsgemäßen Mehrphasensystems wird neben dem Fotolack auch einfach die Metallschicht mit abgelöst. Die Stellen, an denen die Metallschicht direkt mit der Metalloberfläche, beispielsweise einem Siliziumwafer in Kontakt steht, findet keine Ablösung statt. Es verbleibt also eine Metallschicht auf der Metalloberfläche.

Das Verfahren wird durchgeführt, indem das Mehrphasensystem auf die zu behandelnde Oberfläche aufgebracht wird und über einen Zeitraum von 30 Sekunden bis 5 Stunden einwirkt. Anschließend wird das Mehrphasensystem entfernt.

Die Reinigungswirkung der erfindungsgemäßen Mittel besteht dabei in Unterwanderung der Farb- und Metallschicht, häufig begleitet von einer Fragmentierung der Farbschichten und Metallschichten und deren Ablösen vom Untergrund, wobei im Vergleich zum Stand der Technik eine chemische Zersetzung der Schichten nicht zwingend erforderlich ist, sondern vorteilhaft vermieden werden kann. Des Weiteren wird auch ein physikalisches Auflösen vermieden oder weitgehend vermieden. Ermöglicht wird dies durch das erfindungsgemäße Mehrphasensystem.

Das erfindungsgemäße Mehrphasensystem eignet sich deshalb sehr gut als Ersatz für die bisher bekannten hochaggressiven und damit kritischen Reinigungsmittel. Der Einsatz von biologisch abbaubaren, toxikologisch und dermatologisch akzeptablen Inhaltsstoffe bringt zudem Einsparungen im Bereich Entsorgung und Arbeitssicherung mit sich. Neben den sicherheitsrelevanten Aspekten kann durch die neuartigen Reinigungsmittel über ein Mehrphasensystem eine Prozessoptimierung im Hinblick auf Zeit und Durchführung realisiert werden. Prozessschritte können eingespart werden, wie beispielsweise der Nassschritt nach der Plasmaveraschung.

Die Erfindung wird nun anhand von Ausführungsbeispielen näher erläutert, wobei diese nicht einschränkend auf den Schutzumfang zu sehen sind.

### Beispiel 1

| **Inhaltsstoff** | **Gewichtsanteil [Gew.-%]** |
|---|---|
| Wasser, demineralisiert | 25,20 |
| 1-Methoxy-2-propanol | 18,70 |
| Ethylacetoacetat | 22,50 |
| Benzylacetat | 4,80 |
| Benzylalkohol | 6,70 |
| Perfum | 0,80 |
| Öl* | 7,70 |
| Dodecylsulfat-Salz | 7,00 |
| Alkylethoxylat | 6,60 |
| **Summe** | **100,00%** |

### Beispiel 2:

| **Inhaltsstoff** | **Gewichtsanteil [Gew.-%]** |
|---|---|
| Wasser, demineralisiert | 39,45 |
| Diacetonalkohol | 14,00 |
| Ethylacetoacetat | 25,00 |
| Öl* | 3,00 |
| 2-Phenylethanol | 3,75 |
| Alkylethoxylat | 12,00 |
| Dodecylsulfat-Salz | 2,80 |
| **Summe** | **100,00%** |

### Beispiel 3:

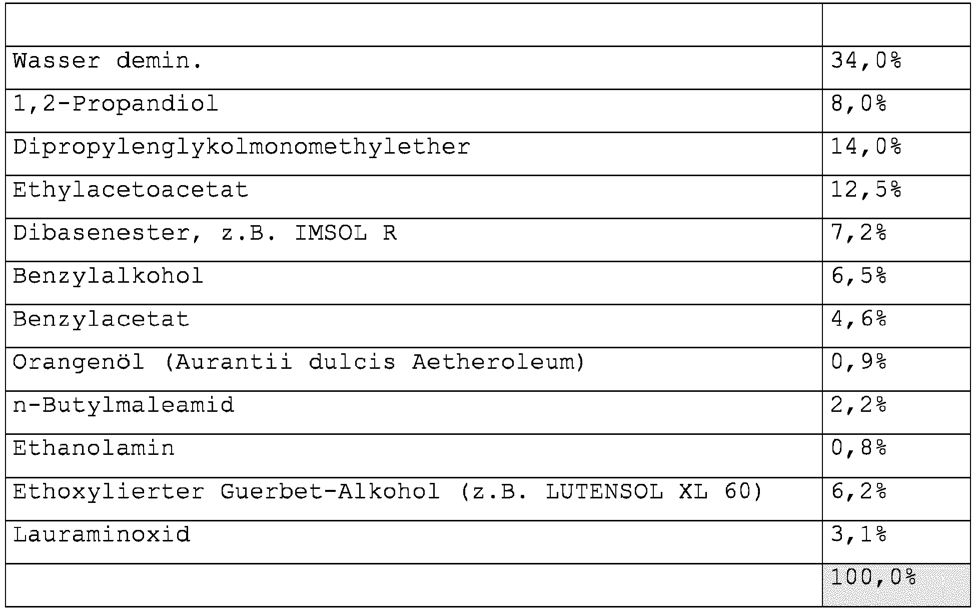

Alle Mehrphasensysteme zeigen einen Trübungswert im Bereich von größer 0 bis - kleiner gleich 200 NTU. Der Trübungswert kann über einen weiten Temperaturbereich von 10 bis 95 °C beibehalten werden. Die Bestimmung des Trübungswertes kann sehr einfach mit einem Turbidimeter, z.B. mit einem Hach 2100 Turbidimeter, erfolgen und ist dem Fachmann bekannt.

## Patentansprüche

1. Verwendung eines Mehrphasensystems zur Entfernung von vernetzten Photoresistlacken von Oberflächen umfassend zwei nicht mischbare Flüssigkeiten, wobei eine der Flüssigkeiten Wasser ist und die andere der beiden Flüssigkeiten eine wasserunlösliche Substanz mit einer Löslichkeit von weniger als 4 g/l in Wasser ist, ferner enthaltend mindestens ein Tensid und gegebenenfalls Zusatz- und/oder Hilfsstoffe, wobei das Tensid ein kationisches, anionisches oder nichtionisches oder amphoteres Tensid ist, **dadurch gekennzeichnet, dass** das Mehrphasensystem einen Trübungswert von größer 0 bis kleiner gleich 200 NTU aufweist, gemessen mit einem Hach 2100 Turbidimeter, wobei die wasserunlösliche Substanz in einer Menge von 1,5-30 Gew.-%, bezogen auf das Gesamtgewicht des Mehrphasensystems, vorhanden ist und wobei das mindestens eine Tensid in einer Menge von 2-20 Gew.-%, bezogen auf das Gesamtgewicht des Mehrphasensystems, vorhanden ist, wobei die wasserunlösliche Substanz aus der Gruppe umfassend Alkane, Cykloalkane, Aromaten, langkettige Alkansäureester, Ester von Di- oder Tricarbonsäuren, Terpene, oder deren Mischungen ausgewählt ist, ferner ein oder mehrere Amphiphile in dem Mehrphasensystem enthalten sind und wobei eines der Amphiphile ausgewählt ist aus Acetoacetaten der Formel III
CH₃-CO-CH₂-CO-O-R₅ [Formel III]
wobei
R₅ ein C₁ bis C₄ Alkyl ist.

2. Verendung Nach Anspruch 1, **dadurch gekennzeichnet, dass** das Acetoacetat der Formel III ausgewählt ist aus Ethylacetoacetat, iso-Propylacetoacetat, Methylacetoacetat, n-Butylacetoacetat, n-Propylacetoacetat oder tert-Butylacetoacetat.

3. Verwendung nach einem der Ansprüche 1 oder 2, wobei die Oberfläche eine nichtmetallische, bevorzugt ein Silizium- oder Glaswafer und/oder eine Metalloberfläche darauf, bevorzugt Kupfer oder Aluminium ist.

4. Verwendung nach einem der Ansprüche 1 bis 3, wobei auf dem Photoresistlack eine Metallschicht aufgebracht ist.

## Claims

1. Use of a multi-phase system for removing crosslinked photoresists from surfaces comprising two immiscible liquids, one of the liquids being water and the other of the two liquids being a water-insoluble substance with a solubility of less than 4 g/l in water, further containing at least one surfactant and optionally additives and/or auxiliaries, the surfactant being a cationic, anionic or nonionic or amphoteric surfactant, **characterized in that** the multiphase system has a turbidity value of greater than 0 to less than or equal to 200 NTU, measured with a Hach 2100 turbidimeter, wherein the water-insoluble substance is present in an amount of 1.5-30% by weight, based on the total weight of the multiphase system, and wherein the at least one surfactant is present in an amount of 2-20% by weight, based on the total weight of the Multi-phase system, is present, the water-insoluble substance is selected from the group consisting of alkanes, cycloalkanes, aromatics, long-chain alkanoic acid esters, esters of di- or tricarboxylic acids, terpenes, or mixtures thereof, one or more amphiphiles are also contained in the multiphase system and one of the amphiphiles is selected from acetoacetates of the formula III
CH₃-CO-CH₂-CO-O-R₅ [Formel III]
wherein
R₅ is C₁ to C₄ alkyl.

2. Use according to claim 1, **characterized in that** the acetoacetate of the formula III is selected from ethyl acetoacetate, isopropyl acetoacetate, methyl acetoacetate, n-butyl acetoacetate, n-propyl acetoacetate or tert-butyl acetoacetate.

3. Use according to one of claims 1 or 2, wherein the surface is a non-metallic, preferably a silicon or glass wafer and/or a metal surface thereon, preferably copper or aluminium.

4. Use according to any one of claims 1 to 3, wherein a metal layer is applied to the photoresist lacquer.

## Revendications

1. Utilisation d'un système multiphasique pour le retrait de résines photosensibles réticulées sur des surfaces, comprenant deux liquides immiscibles dont un des liquides est l'eau et l'autre des deux liquides est une substance insoluble dans l'eau d'une solubilité inférieure à 4 g/l dans l'eau, contenant en outre au moins un surfactant et éventuellement des additifs et/ou agents auxiliaires, le surfactant étant un surfactant cationique, anionique ou non ionique ou amphotère, **caractérisée en ce que** le système multiphasique a un degré de turbidité, mesuré au moyen d'un turbidimètre Hach 2100, supérieur à 0 et inférieur ou égal à 200 UTN, où la substance insoluble dans l'eau est présente à une quantité, rapportée au poids total du système multiphasique, de 1,5-30 % en poids et où l'au moins un surfactant est présent à une quantité, rapportée au poids total du système multiphasique, de 2-20 % en poids, où la substance insoluble dans l'eau est sélectionnée dans le groupe comprenant des alkanes, des cycloalkanes, des aromatiques, des esters d'un acide alkanoïque à longue chaîne, des esters d'acides di- ou tricarboxyliques, des terpènes ou des mélanges de ceux-ci, un ou plusieurs amphiphiles étant en outre contenus dans le système multiphasique et un des amphiphiles étant sélectionné parmi des acétoacétates de Formule III
CH₃-CO-CH₂-CO-O-R₅ [Formule III]
où
R₅ représente un alkyle en C₁ à C₄.

2. Utilisation selon la revendication 1, **caractérisée en ce que** l'acétoacétate de Formule III est sélectionné parmi l'acétoacétate d'éthyle, l'acétoacétate d'isopropyle, l'acétoacétate de méthyle, l'acétoacétate de n-butyle, l'acétoacétate de n-propyle ou l'acétoacétate de tert-butyle.

3. Utilisation selon la revendication 1 ou 2, où la surface est une surface non métallique, préférablement un wafer en silicium ou en verre, et/ou une surface métallique au-dessus, préférablement le cuivre ou l'aluminium.

4. Utilisation selon l'une des revendications 1 à 3, où une couche d'un métal est appliquée sur la résine photosensible.
